# EUROPÄISCHE PATENTANMELDUNG

(11) **EP 0 784 344 A1**
(43) Veröffentlichungstag der Anmeldung: **16.07.1997**
(21) Anmeldenummer: 97100387.6
(22) Anmeldetag: 11.01.1997
(51) Int. Cl.: H01L 27/08

(54) **Halbleiterstruktur zur Schaffung von Widerstandsnetzwerken**

(30) Priorität: 13.01.1996 DE 19601135
(71) Anmelder: Deutsche ITT Industries GmbH, 79108 Freiburg (DE)
(72) Erfinder: Greitschus, Norbert, 79108 Freiburg (DE); Zimmer, Hans-Günter, Dipl.-Phys. Dr., 79211 Denzlingen (DE)

(57) **Zusammenfassung**

Eine Halbleiterstruktur (1) zur Schaffung von Widerstands-netzwerken, insbesondere von Kettenleiteranordnungen, weist aus Halbleitermaterial bestehende Widerstandsabschnitte sowie metallische Anschlußstellen auf. Dabei ist eine durchgehende Widerstandshalbleiterbahn als Hauptzweig (2) vorgesehen. Entlang dieses durchgehenden Hauptzweiges (2) sind entsprechend dem gewünschten Widerstandsteilerverhältnisses und zur Bildung entsprechender Reihenwiderstände (10) seitlich an der Widerstandshalbleiterbahn kontaktierte, metallische Anschlußstellen (7) vorgesehen. Zusätzlich können bei einem insbesondere als Kettenleiteranordnung ausgebildeten Widerstandsnetzwerk Widerstands-halbleiterbahnen als Querzweige (3) jeweils an ihrem einen Ende direkt über das Halbleitermaterial mit der Längsseite des Hauptzweiges (2) verbunden sein. An dem anderen Ende der Querzweige (3) ist jeweils eine metallische Anschlußstelle (7) vorgesehen (Figur 1).

## Beschreibung

Die Erfindung bezieht sich auf eine Halbleiterstruktur zur Schaffung von Widerstandsnetzwerken, insbesondere von Kettenleiteranordnungen, die aus Halbleitermaterial bestehende Widerstandsabschnitte sowie metallische Anschlußstellen aufweisen.

Derartige Halbleiterstrukturen sind bereits bekannt. Beispielsweise werden Kettenleiteranordnungen erzeugt, indem ein aus Halbleitermaterial bestehender Hauptzweig entsprechend dem gewünschten Widerstandsteilerverhältnis und zur Bildung entsprechender Reihenwiderstände in seiner Längserstreckungsrichtung von metallischen Anschlußstellen unterbrochen wird. An diesen metallischen Anschlußstellen ist jeweils über eine Metalleitung ein Querzweig aus Halbleitermaterial zur Bildung der Querwider-stände angeschlossen. Die metallischen Anschlußstellen innerhalb des Hauptzweiges bewirken jedoch unerwünschte, gegebenenfalls sogar nicht-ohmische Kontaktwiderstände, die in Reihe mit den eigentlichen Reihenwiderständen des Hauptzweiges liegen und die Werte der Reihenwiderstände verfälschen. Besonders problematisch ist dabei, daß diese Kontaktwiderstände aus produktionstechnischer Sicht instabil sind, so daß der genaue Wert des Kontaktwiderstandes variiert und nicht vorherbestimmbar ist. Desweiteren kann aufgrund der Kontaktwiderstände der tatsächlich gewünschte Reihenwiderstand nicht beliebig klein realisiert werden, da der Gesamtwiderstand immer mindestens so groß ist wie der doppelte Kontaktwiderstand. Entsprechende Kontaktwiderstände und die damit verbundenen, bereits beschriebenen Probleme, treten auch an den metallischen Verbindungen zwischen dem Hauptzweig und den Querzweigen auf.

Es besteht daher die Aufgabe, eine Halbleiterstruktur der eingangs erwähnten Art zu schaffen, bei der der Einfluß parasitärer Widerstände zumindest weitgehend reduziert ist.

Die Lösung der Aufgabe besteht darin, daß eine durchgehende Widerstandshalbleiterbahn als Hauptzweig vorgesehen ist und daß entlang dieses durchgehenden Hauptzweiges entsprechend dem gewünschten Widerstandsteilerverhältnis und zur Bildung entsprechender Reihenwiderstände seitlich an der durchgehenden Widerstandshalbleiterbahn kontaktierte, metallische Anschlußstellen vorgesehen sind.
Es ergibt sich somit eine Widerstands-Reihenschaltung in dem Hauptzweig, die nicht durch metallische Anschlüsse unterbrochen ist und bei der folglich keine störenden Kontaktwiderstände auftreten. Die Anschlußstellen befinden sich jetzt seitlich neben dem durchgehenden Hauptzweig, wodurch die Kontaktwiderstände in einen Nebenzweig verlagert werden. In praxisüblichen Anwendung, beispielsweise in einer Kettenleiteranordnung, in der diese Nebenzweige den Rückkopplungspfad einer Operationsverstärker-schaltung bilden, sind diese Nebenzweige praktisch stromlos, so daß sich die dort befindlichen Kontaktwiderstände nicht nachteilig auswirken.
Die nach wie vor vorhandenen Kontaktwiderstände sind bei der erfindungsgemäßen Halbleiterstruktur also in einen Bereich verlegt, in dem sie auf die elektrischen Eigenschaften des Widerstands-netzwerkes keinen negativen Einfluß ausüben.
Der Hauptzweig besteht dabei für den Strom durchgängig aus Widerstands-Halbleitermaterial, das heißt es treten innerhalb des
Hauptzweiges keine Halbleiter-Metall-Übergänge auf, die parasitäre Widerstände verursachen und das elektrische Verhalten des Widerstands-Netzwerkes unkontrolliert verändern.
Es ist jedoch möglich, zum Beispiel durch lokale Einbringung von Isolatorstreifen in das Widerstands-Halbleitermaterial des Hauptzweiges oder durch andere, dessen wirksamen Querschnitt beeinflussende Maßnahmen, seinen elektrischen Widerstand gezielt zu beeinflussen, ohne daß dadurch parasitäre Widerstände durch Übergänge des Halbleitermaterials in ein anderes, elektrisch leitendes Material entstehen.

Eine Ausgestaltung der Erfindung sieht vor, daß bei einem insbesondere als Kettenleiteranordnung ausgebildeten Widerstandsnetzwerk Widerstandshalbleiterbahnen als Querzweige jeweils an ihrem einen Ende direkt über das Halbleitermaterial mit der Längsseite des Hauptzweiges verbunden sind und daß an dem anderen Ende der Querzweige jeweils eine metallische Anschlußstelle vorgesehen ist.
Durch die direkte Verbindung der Querzweige mit der Längsseite des Hauptzweiges über das Halbleitermaterial, das heißt durch die Formgebung des Netzwerkes entfallen an diesen Stellen die störenden Anschlußwiderstände. Es tritt lediglich am anderen Ende der Querzweige, an den metallischen Anschlußstellen, ein Anschlußwiderstand auf. Dieser einfache Anschlußwiderstand in dem Querzweig wirkt sich jedoch auf den Gesamtwiderstand des Querzweiges und somit auf das elektrische Verhalten des Netzwerkes nur geringfügig aus, da der Querzweig mit seinem Widerstands-Halbleitermaterial in der Regel ohnehin hochohmig ist und der einzelne Anschlußwiderstand in jedem Querzweig auf den Gesamtwiderstand folglich nur einen geringen, zu vernachlässigenden Einfluß hat.

Es ist vorteilhaft, wenn die Anschlußstellen des Hauptzweiges an der einen Längsseite des Hauptzweiges und die Verbindungen des Hauptzweiges mit den Querzweigen auf der anderen Längsseite angebracht sind. Alle Querzweige liegen dann auf der gleichen Seite des Hauptzweiges, ebenso die seitlich an dem Hauptzweig kontaktierten metallischen Anschlußstellen. Dies vereinfacht die weitere Beschaltung des Widerstandsnetzwerkes innerhalb der Halbleiterstruktur. Beispielsweise können die metallischen Anschlüsse der Querzweige mit einer durchgehenden, linearen Metall-Leitung durchkontaktiert und auf ein gemeinsames Bezugspotential gelegt werden. Durch die beschriebene Anordnung der Anschlußstellen und der Querzweige vereinfacht sich also der Herstellungsprozeß der Halbleiterstruktur, und der Platzbedarf für das Widerstandsnetzwerk wird minimiert.

Es ist zudem vorteilhaft, wenn sich jeweils eine Anschlußstelle des Hauptzweiges und eine Verbindung zwischen dem Hauptzweig und einem Querzweig direkt gegenüberliegen. Die seitlich an der Widerstandshalbleiterbahn des Hauptzweiges kontaktierten, metallischen Anschlußstellen und die Verbindungen zwischen dem Hauptzweig und den Querzweigen bilden dann jeweils einen Knotenpunkt, der auf dem gleichen elektrischen Potential liegt. Dieser gemeinsame Knotenpunkt wird zur Realisierung üblicher Schaltungen, beispielsweise einer Kettenleiteranordnung, benötigt.

Insgesamt läßt sich mit der erfindungsgemäßen Halbleiterstruktur insbesondere eine Kettenleiteranordnung mit einem Hauptzweig und mehreren daran angeschlossenen Querzweigen realisieren, bei der der Hauptzweig durchgehend ohne metallische Anschlußstellen ausgebildet ist und die Halbleiter-Metall-Übergänge für die Anschlußstellen in einen Bereich verlagert sind, der praktisch stromlos ist beziehungsweise so hochohmig, daß ein parasitärer Anschlußwiderstand das elektrische Verhalten des Widerstands-netzwerkes nur in einem zu vernachlässigenden Ausmaß beeinflußt.

Nachstehend ist die Erfindung anhand der Zeichnungen noch näher erläutert.

Es zeigt:
- Figur 1:: Eine schematische Darstellung einer eine Kettenleiteranordnung bildenden Halbleiterstruktur und
- Figur 2:: ein elektrisches Ersatzschaltbild der Halbleiterstruktur gemäß Figur 1

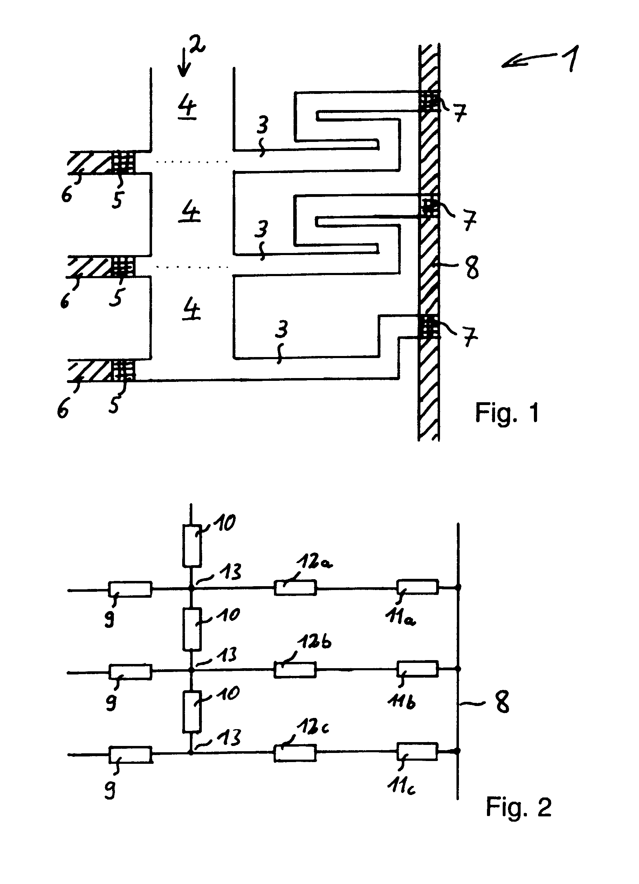

In Figur 1 ist eine im ganzen mit 1 bezeichnete Halbleiterstruktur dargestellt, die als Kettenleiteranordnung ausgebildet ist. Diese besteht aus einem Hauptzweig 2 und mehreren Querzweigen 3. Sowohl der Hauptzweig 2 als auch die Querzweige 3 bestehen durchgehend aus Widerstands-Halbleitermaterial, wobei die Widerstandswerte durch die Geometrie, das heißt insbesondere durch die Leiterbahn-breite und -länge gebildet ist.
Entlang einer Seite des durchgehenden Hauptzweiges 2 sind entsprechend dem gewünschten Widerstandsteilerverhältnis und zur Bildung entsprechender Reihenwiderstände 10 (vrgl. Fig. 2) seitlich an der Widerstandshalbleiterbahn kontaktierte, metallische Anschlußstellen 5 vorgesehen, durch die entsprechende Hauptzweig-abschnitte 4 gebildet sind. An den Anschlußstellen 5 ist jeweils eine Metall-Leitung 6 angeschlossen, die die Anschlußstelle 5 mit weiteren, nicht näher dargestellten Schaltungselementen verbindet.
Durch den Halbleiter-Metall-Übergang an den Anschlußstellen 5 entstehen dort Anschlußwiderstände 9. Diese Anschlußwiderstände 9 liegen jedoch außerhalb des Hauptzweiges, so daß der Hauptzweig elektrisch eine Reihenschaltung von Reihenwiderständen 10, die nur durch das Widerstandshalbleitermaterial des Hauptzweiges 2, nicht aber durch die Anschlußwiderstände 9 bestimmt sind, bildet. Bei entsprechender Beschaltung der Anschlußstellen 5, beispielsweise als Rückkopplungszweig einer Operationsverstärkerschaltung, ist der Strom, der durch die Anschlußwiderstände 9 fließt, praktisch gleich Null, so daß die Anschlußwiderstände 9 das elektrische Verhalten der Halbleiterstruktur 1 nicht beziehungsweise nur in einem minimalen, zu vernachlässigenden Maße beeinflussen.

An der anderen Seite des Hauptzweiges 2 ist jeweils direkt gegenüberliegend zu einer Anschlußstelle 5, ein Querzweig 3 an den Hauptzweig 2 angeschlossen. Die Verbindung zwischen Hauptzweig 2 und Querzweig 3 erfolgt dabei direkt über das Widerstands-Halbleitermaterial, das heißt, die Querzweige sind über die Formgebung und den Verlauf des Halbleitermaterials erzeugt, so daß keine metallischen Anschlüsse zwischen dem Hauptzweig 2 und den Querzweigen 3 erforderlich sind. Die Querzweige 3 sind an ihrem anderen Ende mit einer Anschlußstelle 7 versehen und über eine daran angeschlossene Metall-Leitung 8 miteinander verbunden. Durch die direkte Verbindung des Hauptzweiges 2 und der Querzweige 3 über das Widerstands-Halbleitermaterial entstehen an diesen Stellen keine Anschlußwiderstände. Lediglich an den Halbleiter-Metall-Übergängen zwischen den Anschlußstellen 7 und der Metall-Leitung 8 entsteht jeweils ein Anschlußwiderstand 11a, 11b, 11c (Figur 2). Der Gesamt-Widerstand eines Querzweiges 3 ergibt sich somit aus der Serienschaltung des Querwiderstandes 12a, 12b, 12c des Halbleitermaterials in dem Querzweig 3 und dem Anschlußwiderstand 11a, 11b, 11c. Der Querwiderstand 12a, 12b, 12c ist in der Regel hochohmig ausgelegt, so daß der in Reihe dazu geschaltete Anschlußwiderstand 11a, 11b, 11c den Gesamtwiderstand eines Querzweiges 3 nur minimal beeinflußt.

In Figur 2 ist das elektrische Ersatzschaltbild der Halbleiterstruktur 1 gemäß Figur 1 dargestellt. Der Hauptzweig 2 ist durch die drei Reihenwiderstände 10 entsprechend den Hauptzweigabschnitten 4 in Figur 1 gebildet. An jeden der Knoten 13 ist jeweils ein durch die Anschlußstelle 5 verursachter Anschlußwiderstand 9 sowie in einem separaten Strompfad eine Widerstands-Reihenschaltung angeschlossen. Diese Widerstands-Reihenschaltung wird dabei durch den Querwiderstand 12a, 12b, 12c sowie den Anschlußwiderstand 11a, 11b, 11c gebildet. Die freien Enden der Anschlußwiderstände 11a, 11b, 11c sind über eine Leitung 8 miteinander verbunden.

Durch die Anordnung der Anschlußwiderstände 9 außerhalb des Hauptzweiges 2 ist das Widerstandsteiler-Verhältnis im Hauptzweig 2 nur durch die Reihenwiderstände 10 bestimmt. Es wirken keine störenden Anschlußwiderstände im Hauptzweig 2, die das WiderstandsTeilerverhältnis verfälschen könnten. Die Verlagerung der Anschlußwiderstände 9, 11a, 11b, 11c in Bereiche, die aufgrund der weiteren Beschaltung entweder stromlos oder hochohmig sind, führt in vorteilhafter Weise dazu, daß die Anschlußwiderstände 9, 11a, 11b, 11c das elektrische Verhalten der gesamten Anordnung nicht oder nur minimal, in einem zu vernachlässigenden Rahmen, beeinflussen.

## Patentansprüche

1. Halbleiterstruktur zur Schaffung von Widerstandsnetzwerken, insbesondere von Kettenleiteranordnungen, die aus Halbleitermaterial bestehende Widerstandsabschnitte sowie metallische Anschlußstellen aufweisen, **dadurch gekennzeichnet**, daß eine durchgehende Widerstandshalbleiterbahn als Hauptzweig (2) vorgesehen ist und daß entlang dieses durchgehenden Hauptzweiges (2) entsprechend dem gewünschten Widerstandsteilerverhältnis und zur Bildung entsprechender Reihenwiderstände (10) seitlich an der Widerstandshalbleiterbahn kontaktierte, metallische Anschlußstellen (5) vorgesehen sind.

2. Halbleiterstruktur nach Anspruch 1, dadurch gekennzeichnet, daß bei einem insbesondere als Kettenleiteranordnung ausgebildeten Widerstandsnetzwerk Widerstandshalbleiterbahnen als Querzweige (3) jeweils an ihrem einen Ende direkt über das Halbleitermaterial mit der Längsseite des Hauptzweiges (2) verbunden sind und daß an dem anderen Ende der Querzweige (3) jeweils eine metallische Anschlußstelle (7) vorgesehen ist.

3. Halbleiterstruktur nach Anspruch 2, dadurch gekennzeichnet, daß die Anschlußstellen (5) des Hauptzweiges (2) an der einen Längsseite des Hauptzweiges (2) und die Verbindungen des Hauptzweiges (2) mit den Querzweigen (3) auf der anderen Längsseite angebracht sind.

4. Halbleiterstruktur nach einem der Ansprüche 2 oder 3, dadurch gekennzeichnet, daß sich jeweils eine Anschlußstelle (5) des Hauptzweiges und eine Verbindung zwischen dem Hauptzweig (2) und einem Querzweig (3) direkt gegenüberliegen.
